# EUROPEAN PATENT SPECIFICATION

(11) **EP 3 023 804 B1**
(45) Date of publication and mention of the grant of the patent: **27.11.2019**
(21) Application number: 15191503.0
(22) Date of filing: 26.10.2015
(51) Int. Cl.: G01R 33/09, G01R 33/00

(54) **MAGNETIC INDUCTION MEASURING DEVICE AND METHOD**
VORRICHTUNG UND VERFAHREN ZUM MESSEN EINER MAGNETISCHEN INDUKTION
DISPOSITIF ET PROCÉDÉ DE MESURE DE L'INDUCTION MAGNÉTIQUE

(30) Priority: 21.11.2014 LT 2014134
(43) Date of publication of application: 25.05.2016
(73) Proprietor: Valstybinis moksliniu tyrimu institutas Fiziniu ir technologijos mokslu centras, 02300 Vilnius (LT)
(72) Inventor: STANKEVIC, Voitech, 07100 Vilnius (LT); BALEVICIUS, Saulius, 07187 Vilnius (LT); ZURAUSKIENE, Nerija, 08431 Vilnius (LT); SIMKEVICIUS, Ceslovas, 06137 Vilnius (LT); KERSULIS, Skirmantas, 03205 Vilnius (LT); GOBIS, Vitoldas, 01109 Vilnius (LT); BASKYS, Algirdas, 06116 Vilnius (LT)
(74) Representative: Draugeliene, Virgina Adolfina

(56) References cited:
- EP-A1- 2 040 088
- WO-A1-98/43808
- DE-A1-102008 030 332
- JP-A- 2001 274 478
- US-A1- 2007 096 228

## Description

The present invention relates to instrumentation that is used for the measurement of magnetic fields. The invention can be used in measurement, control and monitoring systems, where permanent or variable scalar magnetic flux density (magnetic induction) is being measured.

In US Patent 6232776 is described a resistive magnetic field sensor, in which the sensing element is a resistor, whose resistance varies depending on the magnetic field. However, since this sensor's resistance also depends on the temperature and on the direction of the magnetic field, this can produce large measurement errors when the measurements are carried out over a wide temperature range and when the direction of the magnetic field is not known in advance. The closest by its technical essence is a device and method for measuring magnetic induction described in EP No 2040088 which measures the absolute value (module) of the magnetic flux density (magnetic induction) independent of the direction of the magnetic field. This device consists of two magnetoresistive sensors, whose resistance varies depending on the magnetic field, but whose resistance and magnetoresistance dependencies on temperature are different. These sensors are made of manganite polycrystalline and monocrystalline thin films, deposited on a non-conductive substrate and four metal contact pads connected to the wires. The connection of these two magnetoresistive elements in series enables the reduction of the temperature dependence of the total resistance and the magnetoresistance. The drawbacks that this magnetic field device has are the difficulty of matching a suitable pair of the magnetoresistive films for use in one sensor, the narrow temperature range in which the device can produce the required accuracy and the additional measurement errors which result when the temperature changes rapidly during a short period of time. Other relevant documents are US2007/096228, WO98/43808, JP2001274478 and DE 102008030332.

The present invention seeks to simplify the manufacture of the device, to expand its operating temperature range and to improve its measurement accuracy in situations where rapid changes of temperature occur.

According to the invention the problem can be solved by the proposed device for measuring magnetic induction comprising a magnetoresistive sensor, having a first dielectric substrate coated with a thin polycrystalline material film whose electrical resistance varies depending on the magnetic field and temperature, where on the thin film locally are formed two electrically conductive contact pads to which connecting leads are attached for connecting a power source so that to form a series electrical circuit through the thin polycrystalline material film placed between contact pads, where the entire device is covered with sealing filler, wherein the device is provided with a resistive temperature sensor, comprising a second dielectric substrate coated with a temperature-sensitive metal thin film which is insensitive to the magnetic field and to which connecting leads are attached for connecting a power source so that to form a series electrical circuit through said temperature sensitive resistive thin metal film, while the first an second substrates of the magnetoresistive and the resistive temperature sensors are positioned opposite one to the other in such a way that their surfaces which are coated with the thin films are parallel to each other, face one another and are separated one from the other by a dielectric heat-conductive intermediate layer.

Outer surfaces of said thin films are coated by a protective film.

The polycrystalline material used for making the magnetoresistive sensor's thin film, whose electrical resistance is dependent on the magnetic field and temperature, can be polycrystalline lanthanum-strontium-manganese oxide or polycrystalline lanthanum-calcium-manganese oxide.

The material used to make the temperature-sensitive resistive sensor's thin metal film is platinum, which can be formed in a meander shape. The dielectric heat-conductive intermediate layer is a thermally softened compound layer.

According to another embodiment of the present invention there is proposed method for measuring magnetic induction comprising the steps of: passing the electric current through a polycrystalline material thin film of a magnetoresistive sensor, whose electrical resistance varies depending on the measured magnetic field and ambient temperature; measuring the electrical resistance of the thin film of polycrystalline material of the magnetoresistive sensor, determining the magnetic induction values according to predetermined functional dependence of this film's electrical resistance on the magnetic field and temperature, wherein simultaneously with the electrical resistance measurement of the magnetoresistive sensor measuring of the resistance of a resistive temperature sensor is performed by passing an electric current through a thin metallic material film of the resistive temperature sensor, whose resistance varies on the temperature and is independent of the magnetic field,
and determining the ambient temperature by predetermined functional dependence of the electrical resistance of the resistive temperature sensor on temperature in real time,
where determining the magnetic induction value is performed according to the measured electrical resistance of the magnetoresistive sensor and according to the predetermined functional dependence of this resistance on the magnetic field at ambient temperature, which was determined by the resistive temperature sensor in real time.

This proposed magnetic induction measuring device and method have the following advantages: it simplifies the making of this device by eliminating the necessity of selecting individual magnetoresistive sensors suitable for use in a single device (probe). Operating temperature range of this device is also much wider, since it can measure the ambient temperature in real time allowing the magnetoresistive sensor to measure the magnetic induction value (scalar magnetic field) at this temperature. This makes it possible to improve the measurement accuracy in rapidly changing temperatures, example, when measuring the magnetic induction of transient processes in powerful electrical machinery. Furthermore, this magnetic field device (probe) is compact allowing it to be used to measure the magnetic flux density (magnetic induction) in small volumes.

As thin polycrystalline manganite film is used in this device, this sensor is also not sensitive to changes of the direction of the magnetic field and measures the values of the scalar magnetic induction.

### Brief description of the drawings:

Fig.1a schematically illustrates a preferred magnetic induction measurement device,
Fig.lb schematically shows the magnetoresistive sensor's view from the thin film side,
Fig.lc schematically shows a resistive sensor's view from the thin film side,
Figure 2a shows diagram of the magnetoresistive sensor's resistance dependence on temperature and magnetic field,
Fig.2b shows the resistive sensor's resistance temperature dependence.

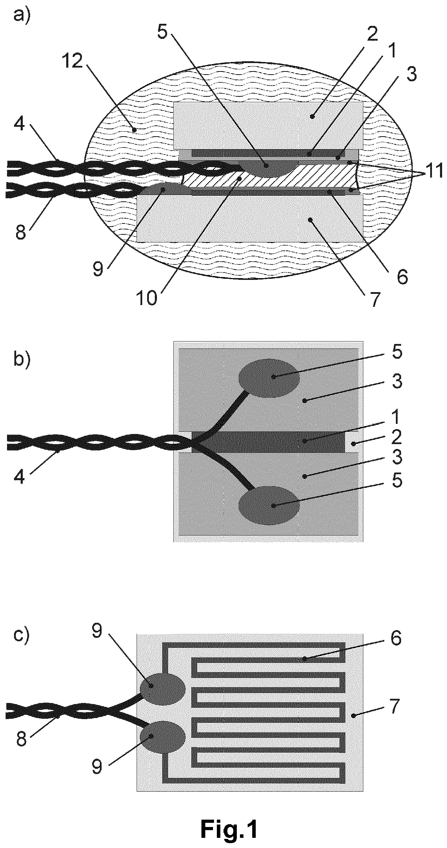

This proposed magnetic induction measuring device (probe) (Figure 1a) has a magnetoresistive sensor, which is made of thin polycrystalline manganite film 1 deposited onto dielectric substrate 2 and whose electrical resistance varies depending on the magnetic field and temperature. Two metal contact pads 3 are formed locally on the thin manganite film 1. Connecting leads 4 for connecting a power source are soldered to the contact pads 3 using solder 5. The device also includes a resistive temperature sensor, which comprises temperature-sensitive thin film 6, formed onto dielectric substrate 7, and whose electrical resistance varies on the temperature and is independent on the magnetic field. Connecting leads 8 for connecting a power source are soldered to the film 6 by means of solder 9. The magnetoresistive sensor and resistive temperature sensor are then positioned so that manganite thin film 1 and temperature sensing film 6 are parallel and face each other. Between them is placed a heat conductive, but electrically non-conductive layer 10 made of a thermally softened compound. This heat-conductive compound layer minimizes the temperature difference between the two sensitive sensor films even when large temperature gradients in ambient temperature are present. To protect sensing films 1 and 6 from direct contact with the thermally softened compound, they are covered with the thin protective film 11. The mounted magnetoresistive sensor and resistive temperature sensor are covered with a sealing filler 12.

The functionality of proposed device was tested by constructing the device in the following manner: 400 nm thick film 1 made of polycrystalline La_{0.83}Sr_{0.17}MnO₃ was deposited onto dielectric lucalox (Al₂O₃ + 0.1% MgO) substrate 2 using the metalorganic chemical vapour deposition (MOCVD) method. Silver contact pads 3 having thicknesses of 1 µm were then deposited onto this film by means of the thermal evaporation method through a stencil. The substrate with the manganite film and contact pads was then divided by means of a diamond disc into 1x0.5 mm² area magnetoresistive sensors. Silver isolated twisted-pair connecting leads 4 were then connected to the contact pads using lead-silver (75% - 35%) solder 5. Such twisted-pair wiring 4 was used in order to avoid the influence of parasitic electromotive forces which can be induced into the wires of the magnetoresistive sensor when placed into a variable magnetic field. The resistive temperature sensor was formed by deposition using thermal evaporation of thin platinum film 6 of 1.5 µm thickness onto rubalite (Al₂O₃ + 0.4% ZrO₂) ceramic substrate 7. The meander-shaped platinum tracks were formed using photolithography. Substrate 7 with platinum film 6 was cut using a diamond disk into elements of 0.9x0.6 mm² area to which silver isolated twisted-pair connecting leads 8 were soldered using solder 9. The sensitive films 1 and 6 of both sensors were then covered with polyethylene film 11. The gap between sensitive films 1 and 6 of the two sensors was filled with heat conductive thermally softened compound (silicone with an aluminum oxide additive layer) 10. The sensors connected in this manner were covered with polyurethane sealing filler 12.

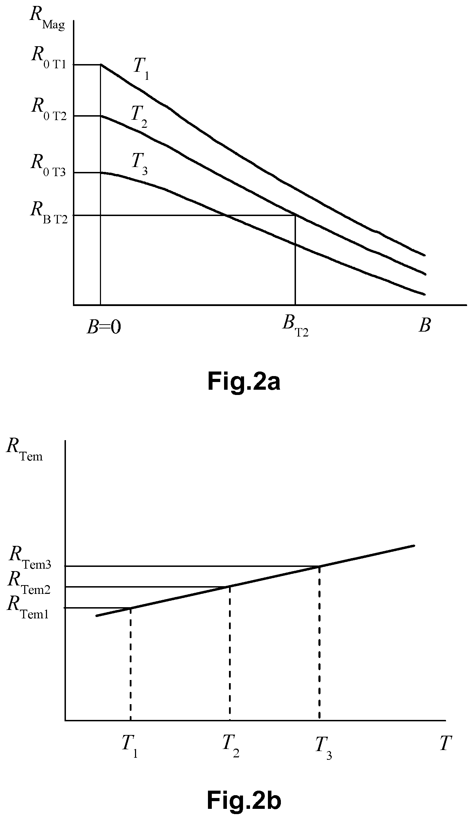

The dependences of the resistance *R*_{Mag} of the magnetoresistive sensor on magnetic induction *B* at various temperatures *T* are shown in Fig. 2a., while the dependence of the resistance of the temperature resistive sensor *R*_{Tem} versus temperature *T* is shown in Fig. 2b. When the ambient temperature increases, the resistance of the resistive temperature sensor increases linearly (Fig. 2b). Thus the ambient temperature can be determined from the measured resistance value of the resistive sensor. As the temperature increases, the resistance of the magnetoresistive sensor drops and, for example, at zero magnetic field induction (B = 0), its resistance values are *R*_{0T1}, *R*_{0T2} and *R*_{0T3}, respectively, when the temperature is *T*₁*, T*₂ and *T*₃. When the magnetic field increases, the resistance of this sensor decreases and magnetoresistance, i.e. the relative resistance change under the same change of magnetic field induction, also decreases (Fig. 2a). Fig. 2a presents the dependences of the resistance of the magnetoresistive sensor on the magnetic field at three fixed temperatures, i.e. *T*₁*, T*₂ and *T*₃.

Both sensors are connected into the electrical circuit. By connecting each sensor separately, for example, to a fixed constant current source (for example 1 mA) (not shown in Fig. 1), we obtain a voltage drop across each sensor proportional to its resistance. The sensors are calibrated during manufacture for its whole operating temperature and magnetic field range, i.e., the resistances of the sensors are measured at different temperatures and magnetic fields and this measurement data is stored in electronic memory. During measurements of the magnetic field induction, the voltage drops across the magnetoresistive and resistive temperature sensors are measured. From the measured voltage drop value (or resistance) of the temperature resistive sensor, the ambient temperature, e.g. *T*₂*,* is calculated (Fig. 2b). The respective dependence of the resistance (or voltage drop) of the magnetoresistive sensor is then selected for this temperature from the magnetic field induction calibration data. Using this dependence, the voltage drop (resistance) across the magnetoresistive sensor is then converted to magnetic induction. For example, the measured resistance (or voltage drop) of magnetoresistive sensor *R*_{BT2} at ambient temperature *T*₂ corresponds to magnetic induction *B*_{T2} (Fig. 2a).

The magnetic flux density or magnetic induction (scalar magnetic field) value (*B*) is calculated using the expression: *B* = *K* [*R*_{0T} - *F*(*R_{BT}, T*)], where *K* is the proportionality factor, *R*_{0T} is the resistance of the magnetoresistive sensor at *B* = 0 and at given temperature *T, F*(*R*_{BT}, *T*) is a function, which is determined in advance during the calibration of the magnetoresistive sensor and depends on temperature *T* and resistance *R*_{BT} of the magnetoresistive sensor in a given magnetic field B at given temperature *T.* Temperature *T* is calculated from the formula *T* = (*R*_{temT} - *R*ₜₑₘ₀) / (*α* • *R*ₜₑₘ₀), where *R*_{temT} is the resistance of the resistive temperature sensor at given temperature *T, R*ₜₑₘ₀ is the resistance of the resistive temperature sensor at temperature *T* = 0°C and α is the temperature coefficient of resistance of the resistive temperature sensor.

In order to increase the sensitivity of the magnetoresistive sensor, polycrystalline manganite La-Sr-Mn-O films, which exhibit higher sensitivity to magnetic field, but weaker resistance and magnetoresistance dependences on temperature in the room-temperature range, can be used. For the measurement of magnetic fields at lower than room temperatures (such as at cryogenic temperatures or in space), polycrystalline La-Ca-Mn-O films can be used as their resistance variation with temperature is smaller and their resistance variation versus the magnetic field is higher at temperatures lower than room temperature.

## Claims

1. Magnetic induction measuring device comprising
a magnetoresistive sensor having a first dielectric substrate (2) coated with thin polycrystalline material film (1), whose electrical resistance varies depending on the magnetic field and temperature, wherein
on the thin polycrystalline material film (1) are formed electrically conductive contact pads (3) to which connecting leads (4) are attached for connecting a power source in order to create a series electrical circuit through the thin polycrystalline material film (1) located between contact pads (3), wherein the entire device is covered with sealing filler (12), **characterized in that** the device is provided with a resistive temperature sensor, comprising a second dielectric substrate (7) coated with thin temperature-sensitive resistive material film (6) which is insensitive to the magnetic field and to which connecting leads (8) are attached for connecting a power source in order to create series electrical circuit through the thin temperature-sensitive resistive film (6), wherein
the first substrate (2) of the magnetoresistive sensor and the second substrate (7) of the resistive sensor are positioned opposite to each other in such a manner that their sides, coated by corresponding said thin films (1) and (6) are parallel and face one another and are separated from each another by dielectric thermally conductive intermediate layer (10).

2. Device according to claim 1, **characterized in that** the outer surfaces of said thin films (1) and (6) are coated by protective film (11).

3. Device according to claim 1 or claim 2, **characterized in that** polycrystalline material of the thin film (1), the electrical resistance of which varies depending on the magnetic field and temperature, is made of polycrystalline lanthanum-strontium-manganese oxide or polycrystalline lanthanum-calcium-manganese oxide.

4. Device according to any one of preceding claims, **characterized in that** temperature-sensitive resistive material of the thin film (6) is a metal film, preferably a platinum film.

5. Device according to claim 4, **characterized in that** the thin platinum film (6) is formed in a meander shape.

6. Device according to any one of preceding claims, **characterized in that** the dielectric thermally conductive intermediate layer (10) is of thermally softened compound.

7. Method for measuring magnetic induction comprising the steps of:
- passing the electric current through a thin polycrystalline material film (1) of a magnetoresistive sensor whose electrical resistance varies depending on the measured magnetic field and ambient temperature,
- measuring the electrical resistance of the thin polycrystalline material film (1) of the magnetoresistive sensor,
- determining the magnetic induction value according to predetermined functional dependence of the resistance of the thin polycrystalline material film (1) on the magnetic field and temperature,
**characterized in that**
simultaneously with the electrical resistance measurement of the magnetoresistive sensor, measuring of the electrical resistance of a resistive temperature sensor is performed by passing an electric current through a thin metallic material film (6) of the resistive temperature sensor, whose resistance varies on the temperature and is independent on the magnetic field,
and
determining the ambient temperature by predetermined functional dependence of the electrical resistance of the resistive temperature sensor on temperature in real time, wherein
determining the magnetic induction value is performed according to the measured electric resistance of the magnetoresistive sensor and according to the predetermined functional dependence of this resistance on the magnetic field at ambient temperature, which was determined by the resistive temperature sensor in real time.

## Patentansprüche

1. Magnetinduktionsmessgerät umfassend einen magnetoresistiven Sensor mit einem ersten dielektrischen Substrat (2), das mit einem dünnen Film aus polykristallinem Material (1) beschichtet ist, dessen elektrischer Widerstand in Abhängigkeit von dem Magnetfeld und der Temperatur variiert, wobei
auf der dünnen polykristallinen Materialfolie (1) elektrisch leitende Kontaktflächen (3) ausgebildet sind, an denen Anschlussleitungen (4) zum Anschließen einer Stromquelle angebracht sind, um eine elektrische Reihenschaltung durch die dünne polykristalline Materialfolie (1) zu schaffen zwischen Kontaktstellen (3), wobei die gesamte Vorrichtung mit abdichtendem Füllstoff (12) bedeckt ist, **dadurch gekennzeichnet, dass** die Vorrichtung mit einem Widerstandstemperatursensor versehen ist, der ein zweites dielektrisches Substrat (7) umfasst, das mit einem dünnen temperaturempfindlichen Widerstandsmaterialfilm beschichtet ist (6), der unempfindlich gegenüber dem Magnetfeld ist und an den Anschlussleitungen (8) zum Anschließen einer Stromquelle angebracht sind, um eine elektrische Reihenschaltung durch den dünnen temperaturempfindlichen Widerstandsfilm (6) zu erzeugen, wobei
das erste Substrat (2) des magnetoresistiven Sensors und das zweite Substrat (7) des resistiven Sensors sind derart gegenüberliegend angeordnet, dass ihre Seiten, die mit den entsprechenden Dünnfilmen (1) und (6) beschichtet sind, parallel sind und einander zugewandt und durch eine dielektrische wärmeleitende Zwischenschicht (10) voneinander getrennt sind.

2. Vorrichtung nach Anspruch 1, **dadurch gekennzeichnet, dass** die Außenflächen der Dünnfilme (1) und (6) mit einem Schutzfilm (11) beschichtet sind.

3. Vorrichtung nach Anspruch 1 oder 2, **dadurch gekennzeichnet, daß** das polykristalline Material der Dünnschicht (1), dessen elektrischer Widerstand sich in Abhängigkeit von Magnetfeld und Temperatur ändert, aus polykristallinem Lanthan-Strontium-Mangan-Oxid oder polykristallinem Lanthan-Calcium-Manganoxid besteht.

4. Vorrichtung nach einem der vorhergehenden Ansprüche, **dadurch gekennzeichnet, dass** das temperaturempfindliche Widerstandsmaterial des Dünnfilms (6) ein Metallfilm, vorzugsweise ein Platinfilm ist.

5. Vorrichtung nach Anspruch 4, **dadurch gekennzeichnet, daß** der dünne Platinfilm (6) mäanderförmig ausgebildet ist.

6. Vorrichtung nach einem der vorhergehenden Ansprüche, **dadurch gekennzeichnet, dass** die dielektrisch wärmeleitende Zwischenschicht (10) aus thermisch erweichtem Verbundwerkstoff besteht.

7. Verfahren zur Messung der magnetischen Induktion umfasst die Schritte:
- Leiten des elektrischen Stroms durch einen dünnen Film aus polykristallinem Material (1) eines magnetoresistiven Sensors, dessen elektrischer Widerstand in Abhängigkeit vom gemessenen Magnetfeld und der Umgebungstemperatur variiert,
- Messen des elektrischen Widerstands des dünnen Films aus polykristallinem Material (1) des magnetoresistiven Sensors,
- Bestimmen des magnetischen Induktionswertes in Abhängigkeit von der vorgegebenen funktionellen Abhängigkeit des Widerstands des dünnen Films aus polykristallinem Material (1) vom Magnetfeld und der Temperatur, **dadurch gekennzeichnet, dass** Gleichzeitig mit der elektrischen Widerstandsmessung des magnetoresistiven Sensors wird die Messung des elektrischen Widerstands eines resistiven Temperatursensors durchgeführt, indem ein elektrischer Strom durch einen dünnen metallischen Materialfilm (6) des resistiven Temperatursensors geleitet wird, dessen Widerstand von der Temperatur abhängt und unabhängig vom Magnetfeld ist, und
Bestimmen der Umgebungstemperatur durch vorgegebene funktionale Abhängigkeit des elektrischen Widerstandes des Widerstandstemperatursensors von der Temperatur in Echtzeit, wobei das Bestimmen des magnetischen Induktionswertes gemäß dem gemessenen elektrischen Widerstand des magnetoresistiven Sensors und gemäß der vorgegebenen funktionalen Abhängigkeit des Widerstands von dem Magnetfeld bei Umgebungstemperatur durchgeführt wird, die vom resistiven Temperatursensor in Echtzeit ermittelt wurde.

## Revendications

1. Dispositif de mesure d'induction magnétique comprenant
un capteur magnétorésistif comportant un premier substrat diélectrique (2) revêtu d'un film mince en matériau polycristallin (1), dont la résistance électrique varie en fonction du champ magnétique et de la température, dans lequel sur le film mince de matériau polycristallin (1) sont formées des plages de contact électriquement conductrices (3) auxquelles sont reliés des conducteurs de connexion (4) pour connecter une source d'alimentation afin de créer un circuit électrique en série à travers le film mince de matériau polycristallin (1) situé entre des plages de contact (3), dans lesquelles tout le dispositif est recouvert d'une charge d'étanchéité (12), **caractérisé en ce que** le dispositif est pourvu d'un capteur de température résistif, comprenant un deuxième substrat diélectrique (7) revêtu d'un film mince de matériau résistif sensible à la température (6) insensible au champ magnétique et auquel sont reliés des conducteurs de connexion (8) pour connecter une source d'alimentation afin de créer un circuit électrique en série à travers le film mince résistif sensible à la température (6), dans lequel
le premier substrat (2)) du capteur magnétorésistif et du deuxième substrat (7) du capteur résistif sont positionnés en regard l'un de l'autre de telle sorte que leurs côtés, revêtus des faces correspondantes Les films minces (1) et (6) sont parallèles et se font face et sont séparés les uns des autres par une couche intermédiaire diélectrique thermoconductrice (10).

2. Dispositif selon la revendication 1, **caractérisé en ce que** les surfaces extérieures des films minces latéraux (1) et (6) sont revêtues d'un film protecteur (11).

3. Dispositif selon la revendication 1 ou la revendication 2, **caractérisé en ce que** le matériau polycristallin du film mince (1), dont la résistance électrique varie en fonction du champ magnétique et de la température, est constitué d'oxyde polycristallin de lanthane-strontium-manganèse ou polycristallin oxyde de lanthane-calcium-manganèse.

4. Dispositif selon l'une quelconque des revendications précédentes, **caractérisé en ce que** le matériau résistif sensible à la température du film mince (6) est un film métallique, de préférence un film de platine.

5. Dispositif selon la revendication 4, **caractérisé en ce que** le film mince de platine (6) a la forme d'un méandre.

6. Dispositif selon l'une quelconque des revendications précédentes, **caractérisé en ce que** la couche intermédiaire diélectrique thermoconductrice (10) est en composé thermo-ramolli.

7. Procédé de mesure de l'induction magnétique comprenant les étapes consistant à:
- faire passer le courant électrique à travers un mince film de matériau polycristallin (1) d'un capteur magnétorésistif dont la résistance électrique varie en fonction du champ magnétique mesuré et de la température ambiante,
- mesurer la résistance électrique du film mince en matériau polycristallin (1) du capteur magnétorésistif,
- détermination de la valeur d'induction magnétique selon une dépendance fonctionnelle prédéterminée de la résistance du film mince de matériau polycristallin (1) au champ magnétique et à la température,
**caractérisé en ce que**
simultanément à la mesure de la résistance électrique du capteur magnétorésistif, la mesure de la résistance électrique d'un capteur de température résistif est effectuée en faisant passer un courant électrique à travers un film mince de matériau métallique (6) du capteur de température résistif, dont la résistance varie avec la température et est indépendant du champ magnétique, et
détermination de la température ambiante par dépendance fonctionnelle prédéterminée de la résistance électrique du capteur de température résistif à la température en temps réel, la détermination de la valeur d'induction magnétique étant effectuée en fonction de la résistance électrique mesurée du capteur magnétorésistif et en fonction de la dépendance fonctionnelle prédéterminée de cette résistance sur le champ magnétique à la température ambiante, déterminée en temps réel par le capteur de température résistif.
